# EUROPEAN PATENT APPLICATION

(11) **EP 2 975 724 A1**
(43) Date of publication of application: **20.01.2016**
(21) Application number: 13877943.4
(22) Date of filing: 14.03.2013
(51) Int. Cl.: H02J 7/00

(54) **ABNORMALITY DIAGNOSIS DEVICE**

(71) Applicant: Automotive Energy Supply Corporation, Zama-shi, Kanagawa 252-0012 (JP)
(72) Inventor: SUNAGA, Kazuhisa, Zama-shi Kanagawa 252-0012 (JP)
(74) Representative: Hoefer & Partner Patentanwälte mbB
(86) International application number: PCT/JP2013/057128
(87) International publication number: WO 2014/141415

(57) **Abstract**

An abnormality diagnosis device includes: a measurement unit (cell voltage measurement unit (202)) for measuring the state of a device to be diagnosed (battery cell); a first abnormality determination unit (overvoltage and over-discharge determination unit (203)) for determining the abnormality of the device to be diagnosed on the basis of the measurement results; and a second abnormality determination unit (main processing unit (301)) for similarly determining the abnormality of the device to be diagnosed on the basis of the measurement results. The measurement unit (202) and the first abnormality determination unit (203) are provided on a first substrate (cell state measurement unit (101)), while the second abnormality determination unit (301) is provided on a second substrate (cell state calculation unit) different from the first substrate, so that the failure rate due to a common failure factor (substrate) is reduced.

## Description

### Technical Field

The present invention relates to an abnormality diagnosis device for diagnosing whether a diagnosis-target device, such as a battery cell for an electric vehicle, is abnormal.

### Background Art

In recent years, electric vehicles have become prevalent, which employ a secondary battery as a power source, and are targeted for solving the CO2 emissions problem. Charge and discharge of such a secondary battery is controlled by a battery management system (henceforth referred to simply as BMS), which has a function of measuring a state, such as a state of charge and a degree of degradation, of the whole of the battery, and also has an abnormality diagnosis function for preventing battery cells from becoming abnormal. Especially, in order to guard a driver from a condition that there is a danger such as heating, for example, an overvoltage state or overdischarge state of a lithium-ion type battery cell, it is necessary for a BMS to ensure reliability of a function of protecting from an overvoltage or overdischarge state, and functional safety in a failed state.

For example, such an abnormality diagnosis performed by a BMS is implemented by measuring voltage of every cell periodically with a cell state measuring section, and determining overvoltage and overdischarge by comparison between the measured voltage and a predetermined threshold value, and at the time of overvoltage and overdischarge, controlling charge-discharge, and thereby protecting the battery cells from overvoltage and overdischarge.

As a typical technique of abnormality diagnosis, a technique is known which employs a plurality of control devices each of which is provided with a self-diagnosis function, as disclosed in a patent document 1.

### Prior Art Document(s)

### Patent Document(s)

Patent Document 1: JP H2-20456 A

### Summary of the Invention

### Problem(s) to be Solved by the Invention

In order to enhance the reliability and functional safety of such an abnormality diagnosis device, it is conceivable to adopt a duplexed or redundant design, where a measurement result about a diagnosis-target device is separated into two or more systems in which abnormality diagnosis is performed. However, if the duplexed or redundant design is implemented by a plurality of calculators (CPUs, MPUs, etc.) mounted on a single board as a common failure factor, it is impossible to treat a failure in the board itself, and it is thereby impossible to reduce the failure rate.

In view of the foregoing, it is an abject of the present invention to enhance the reliability and functional safety by duplex or redundant configuration of abnormality diagnosis, and also reduce the rate of failure due to a common failure factor (board), and thereby further enhance the reliability and the functional safety.

### Means to Solve the Problem(s)

According to the present invention, an abnormality diagnosis device comprises: a measuring section configured to measure a state of a diagnosis-target device; a first abnormality determining section configured to determine whether the diagnosis-target device is abnormal, based on a measurement result obtained by the measuring section; and a second abnormality determining section configured to determine whether the diagnosis-target device is abnormal, based on a measurement result obtained by the measuring section. The measuring section and the first abnormality determining section are provided at a first board; and the second abnormality determining section is provided at a second board other than the first board.

### Effect(s) of the Invention

According to the present invention, it is possible to implement duplex configuration of abnormality diagnosis by provision of two abnormality determining sections, and thereby enhance the reliability and functional safety, and also significantly reduce the rate of failure due to a common failure factor (board) by duplexing by providing the two abnormality determining sections on respective separate boards, and thereby further enhance the reliability and the functional safety.

### Brief Description of the Drawings

FIG. 1 is a configuration diagram showing a battery management system of an electric vehicle as an abnormality diagnosis device according to a first embodiment of the present invention.
FIG. 2 is an illustrative diagram showing a form of connection of the battery management system according to the first embodiment.
FIG. 3 is an illustrative diagram showing a form of connection of a battery management system of an electric vehicle as an abnormality diagnosis device according to a second embodiment of the present invention.
FIG. 4 is a configuration diagram showing a battery management system of an electric vehicle as an abnormality diagnosis device according to a third embodiment of the present invention.

### Mode(s) for Carrying Out the Invention

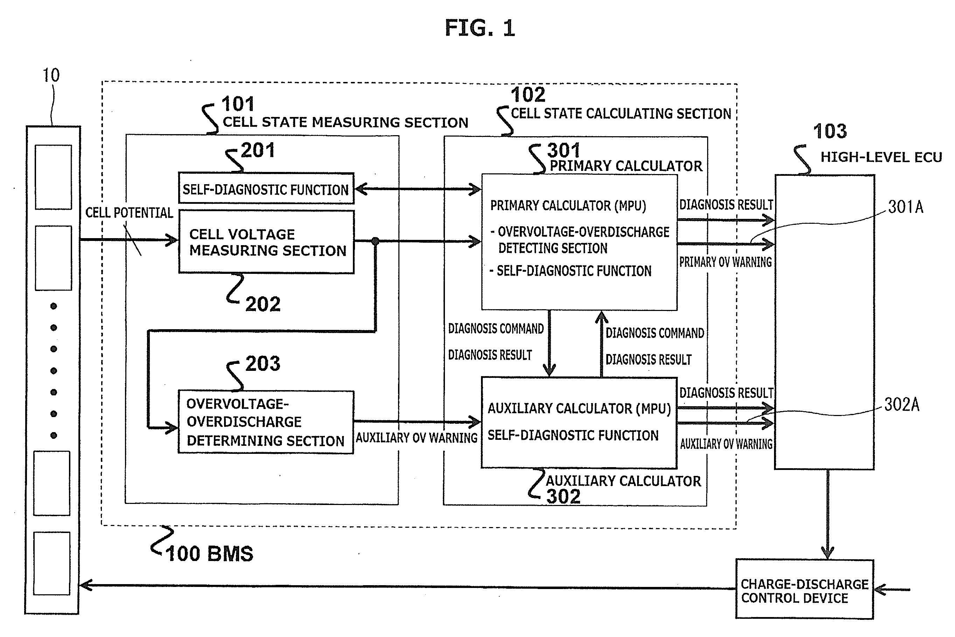

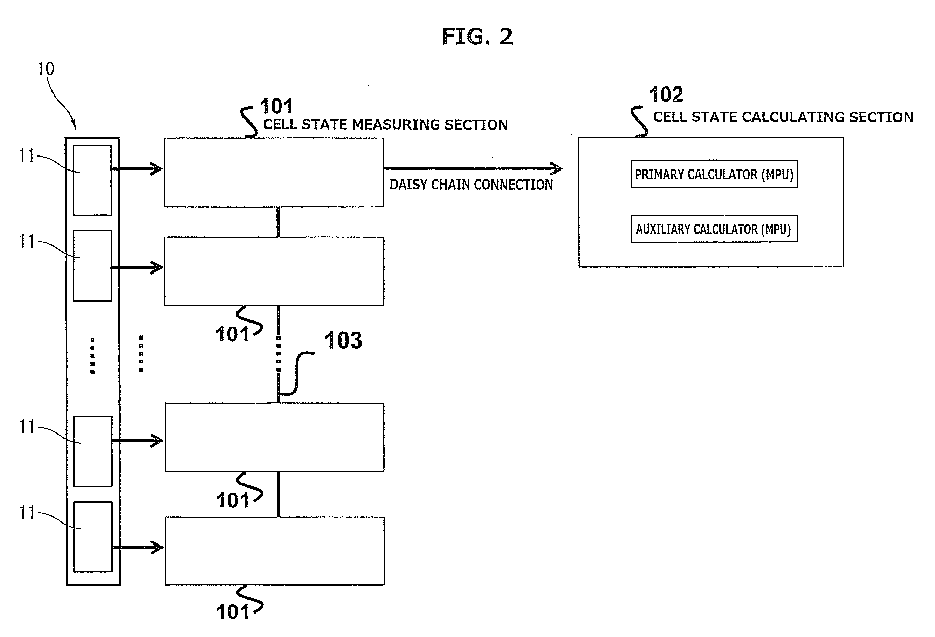

The following describes the present invention with reference to embodiments shown in the drawings. FIGS. 1 and 2 show a battery management system (henceforth referred to also as BMS) 100 as an abnormality diagnosis device according to a first embodiment of the present invention. This battery management system 100 is mounted to an electric vehicle that employs a battery pack 10 as a power source which is a secondary battery of the electric vehicle. Battery pack 10 contains a plurality of battery modules 11. Each battery module 11 includes one of more battery cells as a diagnosis-target device.

Each battery module 11 is electrically connected to a respective cell state measuring section 101 that measures a state, such as voltage, of the battery cells. A cell state calculating section 102 is provided to perform various calculation operations depending on a result of the measurement. Each cell state measuring section 101 is mounted on a first board. Cell state calculating section 102 is mounted on a second board other than the first board.

In this embodiment, the plurality of cell state measuring sections (first board) 101 and cell state calculating section (second board) 102 are connected in series for bidirectional communication by a daisy chain connection using a serial bus 105 or the like, as shown in FIG. 2.

FIG. 1 is a configuration diagram showing battery management system 100. Although FIG. 1 shows only one cell state measuring section 101, one cell state calculating section 102 is actually connected to the plurality of cell state measuring sections 101 as shown in FIG. 2.

Cell state measuring section 101 on the first board is provided with a cell voltage measuring section 202 and an overvoltage-overdischarge determining section 203. Cell voltage measuring section 202 serves as a measuring section to measure voltage of the battery cells of each battery module 11. Overvoltage-overdischarge determining section 203 serves as a first abnormality determining section to determine whether the battery cells as a diagnosis-target device are abnormal, based on a result of the measurement performed by cell voltage measuring section 202. For example, overvoltage-overdischarge determining section 203 compares a measured voltage with an overvoltage threshold value and an overdischarge threshold value, and when the measured voltage is above the overvoltage threshold value, determines that an overvoltage (abnormality) is present, and when the measured voltage is below the overdischarge threshold value, determines that an overdischarge (abnormality) is present, and otherwise, determines that it is normal. When an abnormality is present, overvoltage-overdischarge determining section 203 sends a warning signal (auxiliary OV warning) to an auxiliary calculator 302 described below. Cell voltage measuring section 202 is composed of an AD converter, for example. Overvoltage-overdischarge determining section 203 is composed of a comparator, for example. In this way, each of the plurality of cell state measuring sections 101 connected to each battery module 11 is made to have a simple configuration with no controller such as CPU or MPU and no calculator, which leads to a cost reduction.

In this embodiment, cell voltage measuring section 202 is provided with a self-diagnostic function 201. Alternatively, for simplification, self-diagnostic function 201 may be omitted to configure a primary calculator 301 of cell state calculating section 102 having a calculating function to monitor whether cell voltage measuring section 202 is abnormal.

Cell state calculating section 102 on the second board is provided with two calculators, namely, primary calculator 301 and an auxiliary calculator 302 each of which has a self-diagnostic function. Each of primary calculator 301 and auxiliary calculator 302 is implemented by a micro processing unit (MPU) that is smaller and takes a lower cost than a central processing unit (CPU), and is connected for bidirectional communication to a high-level ECU 103 as a control section via a respective separate interface (communication line) 301A, 302A. High-level ECU 103 is implemented by a central processing unit (CPU) that is capable of memorizing and executing various control operations.

Primary calculator 301 includes an overvoltage-overdischarge detecting section as a second abnormality determining section to determine battery cell abnormality, based on a result of the measurement performed by cell voltage measuring section 202. Primary calculator 301 has a function of performing a self-diagnosis in response to a diagnosis command from auxiliary calculator 302, and sends a result of the diagnosis to auxiliary calculator 302 and high-level ECU 103. When an abnormality is present, primary calculator 301 sends a warning signal (primary OV warning) to high-level ECU 103. Moreover, primary calculator 301 monitors a diagnosis result of the self-diagnosis performed by auxiliary calculator 302, and sends the diagnosis result to high-level ECU 103.

Auxiliary calculator 302 receives a diagnosis result of overvoltage-overdischarge determining section 203 from cell state measuring section 101, and sends the diagnosis result to high-level ECU 103. Auxiliary calculator 302 performs a self-diagnosis in response to a diagnosis command from primary calculator 301, and sends a result of the self-diagnosis to primary calculator 301 and high-level ECU 103. When an abnormality is present, auxiliary calculator 302 sends a warning signal (auxiliary OV warning) to high-level ECU 103. Moreover, auxiliary calculator 302 monitors a diagnosis result of the self-diagnosis performed by primary calculator 301, and sends the diagnosis result to high-level ECU 103.

A charge-discharge control device 104 performs a charge-discharge control for battery pack 10 in response to a command signal from high-level ECU 103.

In this way, according to the present embodiment, the provision of overvoltage-overdischarge determining section 203 and the second overvoltage-overdischarge determining section (primary calculator 301) as two abnormality determining sections, serves to make the abnormality diagnosis duplex and redundant, and thereby enhance the reliability and safety, and the dual redundant configuration by providing them to separate boards, serves to reduce a failure rate due to a common failure factor, and thereby further enhance the reliability and abnormality diagnosis rate, as compared to a configuration where both are provided on a signal board (common failure factor).

The dual redundant configuration where two calculators, namely, primary calculator 301 and auxiliary calculator 302 are provided in cell state calculating section 102 mounted on the second board, serves to further enhance the reliability and thereby reduce the failure rate.

Moreover, the configuration that each of primary calculator 301 and auxiliary calculator 302 is implemented by a simple micro processing unit (MPU) with no control function, serves to reduce the cost as compared to a case where a CPU capable of memorizing and executing various control operations is employed, and the configuration that each of primary calculator 301 and auxiliary calculator 302 performs a self-diagnosis in response to a diagnosis command from each other, achieves a self-diagnosis function. The configuration that primary calculator 301 and auxiliary calculator 302 monitor abnormality of each other, serves to further enhance the reliability and the functional safety.

The configuration that each of primary calculator 301 and auxiliary calculator 302 is connected for communication to high-level ECU 103 via a respective different communication interface 301A, 302A, namely, the duplex configuration of interfaces 301A, 302A, serves to further enhance the reliability and the functional safety.

Moreover, according to the first embodiment, the configuration that the plurality of cell state measuring sections 101 and the single cell state calculating section 102 are connected in series by daisy chain connection, serves to shorten and simplify communication line configuration.

Although the present invention has been described with reference to the specific embodiment, the present invention is not limited to the embodiment, but includes variations and modifications as shown in the following embodiments. In the following embodiments, explanation is focused mainly on part different from the embodiment describe above, and the same reference symbols are assigned to the same components, and repetition of explanation is suitably omitted.

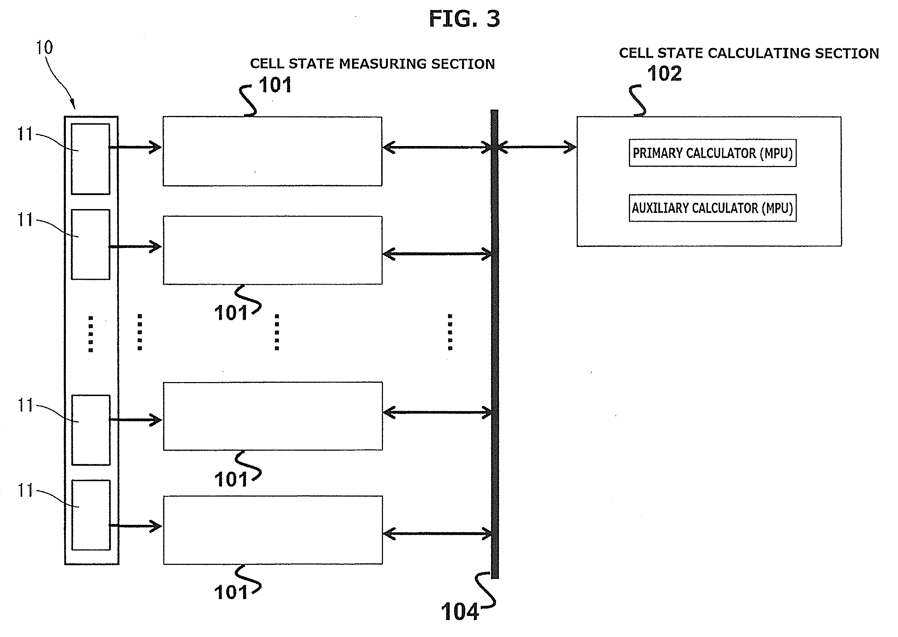

FIG. 3 shows a form of connection of a battery management system according to a second embodiment of the present invention. In this second embodiment, the plurality of cell state measuring sections 101 are connected for bidirectional communication in parallel to cell state calculating section 102 via a common data bus 106 that is a communication line composed of known CAN communication or the like. Even with such a connection form, it is possible to obtain the same operation effects as in the first embodiment.

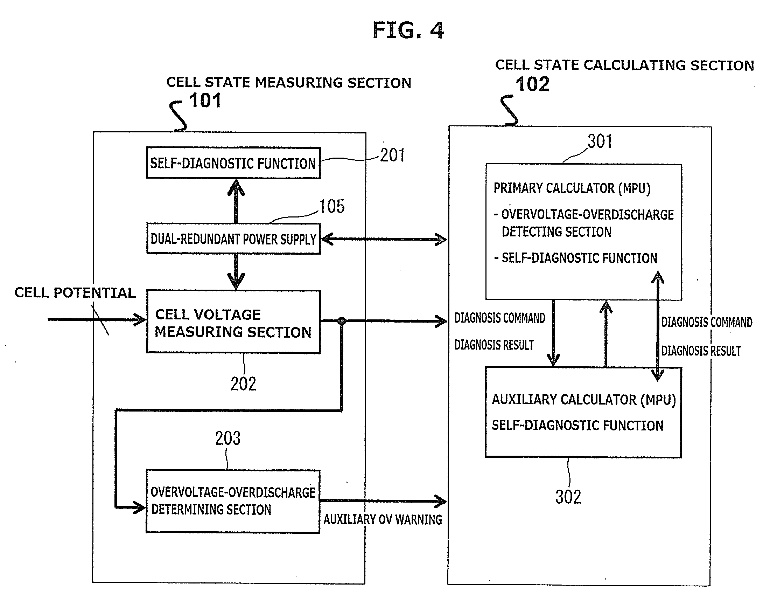

FIG. 4 shows a battery management system according to a third embodiment of the present invention. In this third embodiment, in addition to the configuration of the first embodiment shown in FIG. 1, a dual-redundant power supply 107 is provided which has dual power supply lines for supplying power to cell voltage measuring section 202. Specifically, power can be supplied to cell voltage measuring section 202 from a backup battery having a small capacity, such as a 12V battery, as well as from battery pack 10 having a large capacity for vehicle driving. According to the third embodiment, the dual redundant provision of power supplies serves to further enhance the reliability and the functional safety.

## Claims

1. An abnormality diagnosis device comprising:
a measuring section configured to measure a state of a diagnosis-target device;
a first abnormality determining section configured to determine whether the diagnosis-target device is abnormal, based on a measurement result obtained by the measuring section;
a second abnormality determining section configured to determine whether the diagnosis-target device is abnormal, based on a measurement result obtained by the measuring section;
a first board where the measuring section and the first abnormality determining section are provided; and
a second board where the second abnormality determining section is provided.

2. The abnormality diagnosis device as claimed in Claim 1, wherein a plurality of the first boards and the second board are connected in series for communication thereamong.

3. The abnormality diagnosis device as claimed in Claim 1, wherein a plurality of the first boards are connected to the second board in parallel for communication therebetween.

4. The abnormality diagnosis device as claimed in any one of Claims 1 to 3, wherein the first board is connected to two different power supply lines.

5. The abnormality diagnosis device as claimed in any one of Claims 1 to 4, wherein:
a primary calculating section and an auxiliary calculating section are provided at the second board: and
each of the primary calculating section and the auxiliary calculating section is configured to perform a self-diagnosis in response to a diagnosis command from each other.

6. The abnormality diagnosis device as claimed in Claim 5, wherein each of the primary calculating section and the auxiliary calculating section is connected to a control section through a different communication interface for communication therebetween.

7. The abnormality diagnosis device as claimed in Claim 6, wherein the primary calculating section includes the second abnormality determining section, and is configured to:
perform the self-diagnosis in response to the diagnosis command from the auxiliary calculating section;
monitor a diagnosis result of the self-diagnosis performed by the auxiliary calculating section; and
send to the control section the diagnosis result and a result of the determination performed by the second abnormality determining section.

8. The abnormality diagnosis device as claimed in Claim 6 or 7, wherein the auxiliary calculating section is configured to:
receive a result of the determination performed by the first abnormality determining section;
perform the self-diagnosis in response to the diagnosis command from the primary calculating section;
monitor a diagnosis result of the self-diagnosis performed by the primary calculating section; and
send to the control section the diagnosis result and the result of the determination.

9. The abnormality diagnosis device as claimed in any one of Claims 1 to 8, wherein:
the diagnosis-target device is a battery cell of an electric vehicle; and
the first abnormality determining section and the second abnormality determining section are configured to determine or detect overvoltage and overdischarge of the battery cell.
